# EUROPÄISCHE PATENTSCHRIFT

(11) **EP 1 971 504 B1**
(45) Veröffentlichungstag und Bekanntmachung des Hinweises auf die Patenterteilung: **05.08.2009**
(21) Anmeldenummer: 07821402.0
(22) Anmeldetag: 16.10.2007
(51) Int. Cl.: B60R 1/08, G02B 5/10, C03C 17/36, C03C 17/42, C23C 14/06, C23C 14/08, C23C 14/18, C23C 14/56

(54) **BLENDARME SPIEGELSCHEIBE SOWIE RÜCKSPIEGEL MIT EINER SOLCHEN SPIEGELSCHEIBE**
LOW GLARE MIRROR PLATE AND REAR-VIEW MIRROR WITH THIS TYPE OF MIRROR PLATE
VITRE-MIROIR ANTIREFLET ET RETROVISEUR DOTE D'UNE VITRE-MIROIR DE CE TYPE

(30) Priorität: 17.10.2006 DE 202006015876 U
(43) Veröffentlichungstag der Anmeldung: 24.09.2008
(73) Patentinhaber: MEKRA Lang GmbH & Co. KG, 90765 Fürth (DE); Leybold Optics Dreden GmbH, 01109 Dresden (DE)
(72) Erfinder: SINGER, Jürgen, 90574 Rostal (DE); LANG, Werner, 91465 Ergersheim (DE); FUKAREK, Wolfgang, 01477 Fischbach (DE)
(74) Vertreter: Winter, Brandl, Fürniss, Hübner Röss, Kaiser, Polte Partnerschaft Patent- und Rechtsanwaltskanzlei
(86) Internationale Anmeldenummer: PCT/EP2007/061037
(87) Internationale Veröffentlichungsnummer: WO 2008/046830

(56) Entgegenhaltungen:
- WO-A-01/69291
- WO-A-99/08974
- US-A1- 2006 029 816

## Beschreibung

Die Erfindung betrifft eine blendarme Spiegelscheibe gemäß Anspruch 1, ein Verfahren zu dessen Herstellung sowie einen blendarmen Rückspiegel für Kraftfahrzeuge nach Anspruch 14.

Herkömmliche Spiegelbeschichtungen aus Silber sind trotz Versiegelung oft anfällig gegen Korrosion, was zur Beeinträchtigung des Sichtfeldes und schließlich zum vollständigen Funktionsausfall des Spiegels führt. Darüber hinaus soll die störende Blendwirkung sowohl nachts als auch tagsüber vermindert werden, d.h. es wird angestrebt über den gesamten Wellenlängenbereich des sichtbaren Lichts Blendarmut zu erzielen. Das menschlich Auge besitzt bei heller Umgebung bzw. bei Tageslicht eine maximale spektrale Empfindlichkeit bei 555 nm, d. h. bei gelb-grünen Farbtönen. Bei dunkler Umgebung bzw. bei Nacht verschiebt sich diese maximale spektrale Empfindlichkeit des menschlichen Auges in Richtung blauer Farbtöne. Ein Spiegel mit höherem Reflexionsgrad im blauen Spektralbereich ist daher für den Einsatz bei Tag und Nacht besonders geeignet. Auch aus ästhetischen Gründen sollen Spiegel manchmal einen bläulichen Farbton aufweisen.

Ein derartiger Spiegel ist aus der EP-B-1099671 bekannt. Dieser bekannte Vorderflächenspiegel nutzt Chrom als Spiegelschicht und ist daher sehr korrosionsstabil. Durch zusätzliche Schichten Al₂O₃, ZrO₂, SnO₂ und TiO₂ wird die störende Blendwirkung reduziert. Der Reflexionsgrad derartiger Spiegel ist im Bereich des kurzwelligen sichtbaren Spektrums (blaue Farbtöne) größer als im Bereich des langwelligen sichtbaren Spektrums (rote Farbtöne). Hierdurch ergibt sich für derartige Spiegel ein bläulicher Farbton. Problematisch bei den bekannten Blauspiegeln ist die Homogenität des Blautones über die gesamte Spiegelfläche.

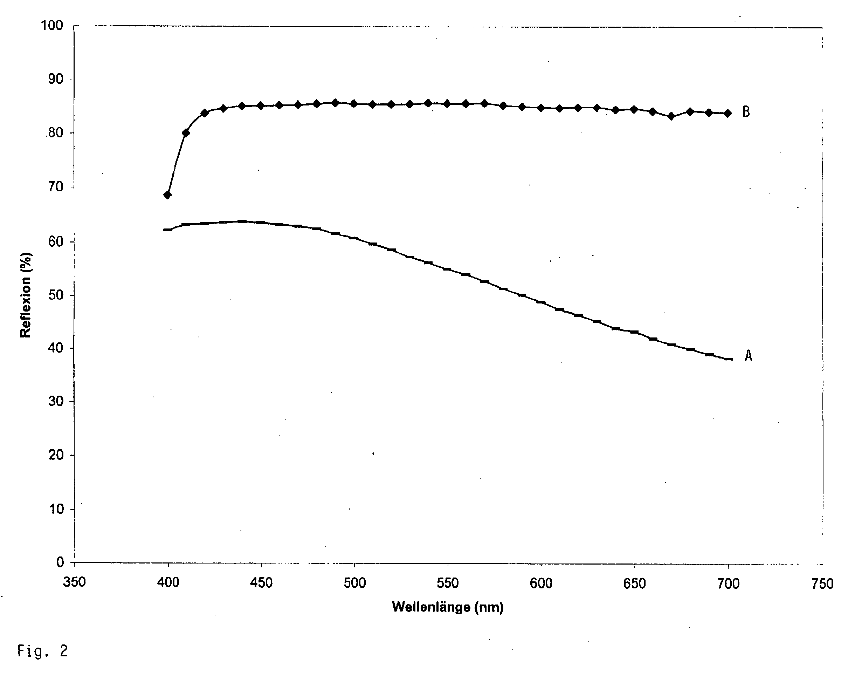

WO 01/69291 A zeigt in Figur 2 eine blendarme Spiegelscheibe mit einem durchsichtigen Substrat (Figur 2, "glass substrate 12") mit einer Vorderseite, die die Vorderseite der Spiegelscheibe bildet, und einer Rückseite, einer auf der Rückseite des Substrats aufgebrachten ersten Schicht aus Nioboxid (Figur 2, "base film 14", Seite 7, Zeilen 11,12) und einer auf einer zweiten Schicht aufgebrachten dritten Schicht bzw. Spiegelschicht aus Chrom (Figur 2, "metal film 18" mit "reflective interface 22", Seite 9, Zeilen 13 - 15).

Die gattungsbildende US 2006/029816 A1 zeigt in Figur 1 ein Trägersubstrat aus Glas ("glass substrate 2"), eine darauf aufgesputterte dielektrische Schicht ("first dielectric antireflecting layer 3") aus Niobiumoxid (Absatz [0074]) und eine weitere dielektrische aufgesputterte Schicht ("second dielectric haze reducing layer 5") aus Siliziumnitrid (Absatz [0075]).

Um eine Blendminderung zu erzielen ist es auch bekannt die für das menschliche Auge auch nachts störenden Wellenlängen des sichtbaren Lichts, dies sind überwiegend Blautöne, aus dem Spektrum zu eliminieren, d. h. der Reflexionsgrad dieser Spiegel ist im blauen Wellenlängenbereich geringer als im roten Wellenlängenbereich. Dies hat zur Folge, dass der Spiegel rot erscheint. Außerdem reflektieren solche Rotspiegel im Wellenlängenbereich, in dem die Normlichtart A ihr Maximum an Intensität aufweist - im roten Bereiche - sehr viel Licht, was somit auch tagsüber eine Blendwirkung zur Folge hat.

Es ist daher Aufgabe der vorliegenden Erfindung einen blendarme Spiegelscheibe und einen blendarmen Rückspiegel für Kraftfahrzeuge mit einer solchen blendarmen Spiegelscheibe anzugeben, die einen vernünftigen Kompromiss zwischen verminderter Blendwirkung tagsüber und Nachts bereitstellt.

Die Lösung dieser Aufgabe erfolgt durch die Merkmale des Anspruchs 1 bzw. 14.

Durch die Kombination einer auf dem durchsichtigen Substrat aufgebrachten Schicht aus Nioboxid (Nb₂O₅), einer auf der Nioboxidschicht aufgebrachten farbgebenden Schicht aus Siliziumnitrid (Si₃N₄) und einer Chromschicht als Spiegelschicht wird zum einen ein ausreichend verminderte Blendwirkung bei Tag und bei Nacht erreicht und die bläuliche Farbwirkung der Spiegelscheibe ist über die gesamte Fläche der Spiegelscheibe sehr homogen.

Die Spiegelscheibe weist über den gesamten Spektralbereich des sichtbaren Lichts einen verminderten Reflexionsgrad auf; bei 700nm Wellenlänge ca.32%, bei 400nm Wellenlänge ca. 65%. Der angestrebte bläuliche Farbton weist eine unverwechselbare Farbwiedergabe auf. Damit wurde erstmals ein Rückflächen-Blauspiegel mit sehr homogenen Farbverlauf unter Verwendung von Nioboxid und Siliziumnitrid bereitgestellt, der aufgrund seiner Chrombasis eine sehr gute Korrosionsstabilität aufweist.

Die Ausgestaltungen der Erfindung nach Anspruch 4 hinsichtlich des angestrebten Kompromisses zwischen verminderter Blendwirkung bei Tag und bei Nacht vorteilhaft.

Durch die vorteilhaften Ausgestaltungen der Erfindung nach den Ansprüchen 5 bis 7 werden die gewünschten Reflexikonsgrade und die gewünschte bläuliche Farbgebung besonders gut erreicht.

Durch die leichte Krümmung gemäß Anspruch 8 eignet sich die blendarme Spiegelscheibe insbesondere für Rückspiegel von Kraftfahrzeugen.

Glas ist als Substrat oder Träger - Anspruch 9 - der einzelnen Schichten der Spiegelscheibe besonders geeignet, da Glas hervorragende optische und mechanische Eigenschaften aufweist. Es können jedoch auch durchsichtige Kunststoffe als Substrat verwendet werden.

Das Verfahren nach Anspruch 11 stellt eine vorteilhafte Möglichkeit der Herstellung der erfindungsgemäßen Spiegelscheibe dar.

Die weiteren Unteransprüche beziehen sich auf weitere vorteilhafte Ausgestaltungen der Erfindung.

Weitere Einzelheiten, Merkmale und Vorteile der Erfindung ergeben sich aus der nachfolgenden Beschreibung einer bevorzugten Ausführungsform anhand der Zeichnungen.

### Es zeigt:

- Fig. 1: eine schematische Schnittdarstellung des Schichtaufbaus einer Spiegelscheibe gemäß der vorliegenden Erfindung; und
- Fig. 2: eine grafische Darstellung des Reflexionsgrades einer Spiegelscheibe gemäß der vorliegenden Erfindung als Funktion der Wellenlänge.

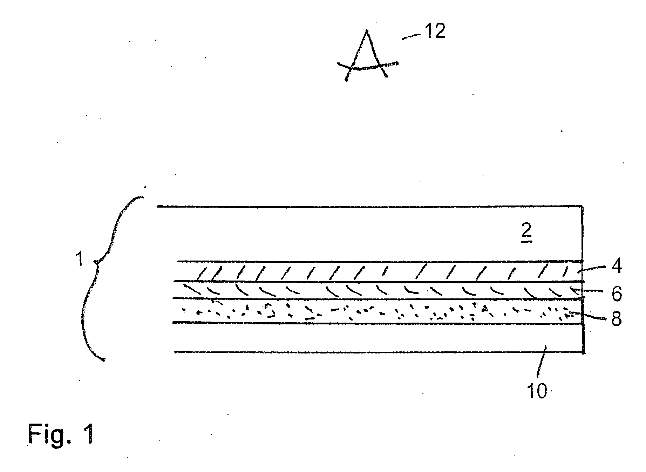

Fig. 1 zeigt den Schichtaufbau einer beispielhaften Ausführungsform einer Spiegelscheibe 1 gemäß der vorliegenden der Erfindung. Auf einem Substrat oder Träger 2 aus Glas ist eine erste Schicht 4 aus Nioboxid, genauer Niobpentoxid Nb₂O₅, aufgebracht. Auf der Nioboxidschicht 4 ist eine zweite Schicht 6 aus Siliziumnitrid Si₃N₄ aufgebracht. Auf der Siliziumnitridschicht 6 ist schließlich eine dritte Schicht 8 aus Chrom als Spiegelschicht aufgebracht. Auf der Spiegelschicht 8 ist ein Schutzlack 10 aufgebracht, um die Spiegelschicht 8 aus Chrom vor mechanischer Beschädigung zu schützen. Der Schutzlack 10 ist zur Aufrechterhaltung der Korrosionsstabilität nicht notwendig. Das Bezugszeichen 12 bezeichnet einen Betrachter der Spiegelscheibe 1.

Die Nioboxidschicht 4 weist eine Dicke von 38nm ± 10nm, die Siliziumnitridschicht 6 weist eine Dicke von 49nm ± 20nm und die Spiegelschicht 8 aus Chrom weist eine Dicke von 50nm ± 10nm auf. Die Dicken der einzelnen Schichten 4, 6 und 8 sind so gewählt, dass sich die gewünschten Reflexionsgrade von über 40% - Bedingung für den Einsatz in Kraftfahrzeugen-ergeben und gleichzeitig eine ausreichende Blendfreiheit bei Tag und bei Nacht gewährleisten.

Das Aufbringen der Schichten 4, 6 und 8 erfolgt durch Sputtern. Hierfür werden Inline-Sputteranlagen der Firma Leybold Optics verwendet. Bei diesen Anlagen sind Substrat 2 und die einzelnen Targets für die verschiedenen Schichten senkrecht nebeneinander angeordnet. Die verschiedenen Targets sind nacheinander ortsfest angeordnet, während das Substrat linear an den Targets entlang bewegt wird. Für die Nioboxidschicht 4 wird ein Target aus Nioboxid und für die Spiegelschicht 8 aus Chrom wird ein Target aus Chrom verwendet. Für die Siliziumnitridschicht 6 wird ein Target aus reinem Silizium verwendet. Das Silizium reagiert in lokaler Stickstoff enthaltender Atmosphäre nach der Reaktionsformel

3 Si+2 N₂→Si₃N₄

zu Siliziumnitrid, das sich dann auf der Nioboxidschicht 4 niederschlägt.

Fig. 2 zeigt eine grafische Darstellung des Reflexionsgrades einer Spiegelscheibe nach Fig. 1 als Funktion der Wellenlänge. Die Kurve A stellt den Reflexionsgrad (in %) des Spiegels als Funktion der Wellenlänge (in nm) des auf den Spiegel einfallenden Lichts dar. Dieser spektrale Reflexionsgrad variiert im Bereich zwischen 400nm und 700nm zwischen maximal 63% und minimal 48%. Die Kurve B zeigt die spektrale Reflexion eines Standardreflelektors.

### Bezugszeichenliste:

- 1: Spiegelscheibe
- 2: Glassubstrat
- 4: erste Schicht aus Nioboxid
- 6: zweite Schicht aus Siliziumnitrid
- 8: dritte Schicht aus Chrom, Spiegelschicht
- 10: Schutzlack
- 12: Betrachter

## Patentansprüche

1. Blendarme Spiegelscheibe, insbesondere für Rückspiegel von Kraftfahrzeugen, mit
einem durchsichtigen Substrat (2) mit einer Vorderseite, die die Vorderseite der Spiegelscheibe (1) bildet, und einer Rückseite,
einer auf der Rückseite des Substrats (2) aufgebrachten ersten Schicht (4) aus Nioboxid,
einer auf der ersten Schicht (4) aufgebrachten zweiten Schicht (6) aus Siliziumnitrid, **gekennzeichnet durch**
eine auf der zweiten Schicht (6) aufgebrachte dritte Schicht (8) bzw. Spiegelschicht (8) aus Chrom.

2. Blendarme Spiegelscheibe nach Anspruch 1, **dadurch gekennzeichnet, dass** die erste, zweite und/oder dritte Schicht (4, 6, 8) gesputterte Schichten sind.

3. Blendarme Spiegelscheibe nach Anspruch 1 oder 2, **dadurch gekennzeichnet, dass** die Dicken der ersten und zweiten Schicht (4, 6) so gewählt sind, dass der Reflexionsgrad der Spiegelscheibe (1) im Bereich des kurzwelligen sichtbaren Spektrums größer ist als im Bereich des langwelligen sichtbaren Spektrums.

4. Blendarme Spiegelscheibe nach einem der vorhergehenden Ansprüche, **dadurch gekennzeichnet, dass** die Schichtdicken der ersten, zweiten und dritten Schicht (4, 6, 8) so gewählt sind, dass der integrale Reflexionsgrad der Spiegelscheibe (1) im Bereich zwischen 43% und 53%, vorzugsweise zwischen 48% und 52% und bevorzugt zwischen 49% und 51 % liegt.

5. Blendarme Spiegelscheibe nach einem der vorhergehenden Ansprüche, **dadurch gekennzeichnet, dass** die die Dicke der ersten Schicht (4) aus Nioboxid 38nm ± 10nm beträgt.

6. Blendarme Spiegelscheibe nach einem der vorhergehenden Ansprüche, **dadurch gekennzeichnet, dass** die Dicke der zweiten Schicht (6) aus Siliziumnitrid 49nm ± 20nm beträgt.

7. Blendarme Spiegelscheibe nach einem der vorhergehenden Ansprüche, **dadurch gekennzeichnet, dass** die Dicke der Spiegelschicht (8) aus Chrom 50nm ± 10nm beträgt.

8. Blendarme Spiegelscheibe nach einem der vorhergehenden Ansprüche, **dadurch gekennzeichnet, dass** das Substrat (2) leicht gekrümmt ist.

9. Blendarme Spiegelscheibe nach einem der vorhergehenden Ansprüche, **dadurch gekennzeichnet, dass** das Substrat (2) aus Glas besteht.

10. Blendarme Spiegelscheibe nach einem der vorhergehenden Ansprüche, **dadurch gekennzeichnet, dass** auf der Spiegelschicht (8) aus Chrom eine vierte Schicht aus Schutzlack (10) aufgebracht ist.

11. Verfahren zur Herstellung einer Spiegelscheiben nach einem der vorhergehenden Ansprüche mit den Verfahrensschritten:
- Bereitstellen eines Substrats (2) in einer InLine-Sputteranlage,
- Aufsputtern der ersten Schicht (4) aus Nioboxid auf die Rückseite des Substrats (2) aus einem Nioboxid-Target,
- Aufsputtern der zweiten Schicht (6) aus Siliziumnitrid auf die erste Schicht (4) aus einem Silizium-Target unter Zugabe von Stickstoff,
**gekennzeichnet durch**
- Aufsputtern der Spiegelschicht (8) aus Chrom auf die zweite Schicht (6) aus einem Chrom-Target.

12. Verfahren nach Anspruch 11, **gekennzeichnet durch** den Verfahrensschritt des Aufbringens einer vierten Schicht aus Schutzlack (10) auf die Spiegelschicht (8).

13. Verfahren nach einem der vorhergehenden Ansprüche 11 bis 12, **dadurch gekennzeichnet, dass** Substrat (2) an den ortsfesten Targets vorbeigeführt wird.

14. Blendarmer Rückspiegel für Kraftfahrzeuge mit einer Spiegelscheibe (1) nach einem der vorhergehenden Ansprüche 1 bis 10.

## Claims

1. Low glare mirror plate, in particular for the rearview mirror of motor vehicles with a transparent substrate (2) having a front side, which forms the front side of the mirror plate (1), and a rear side, a first layer (4) of niobium pentoxide applied onto the rear side of the substrate (2), a second layer (6) of silicon nitride applied onto the first layer (4), **characterised by** a third layer (8) or mirror layer (8) of chromium applied onto the second layer (6).

2. Low glare mirror plate according to claim 1, **characterised in that** the first, second and/or the third layers (4, 6, 8) are sputtered layers.

3. Low glare mirror plate according to claim 1 or 2, **characterised in that** the thicknesses of the first and second layers (4, 6) are selected such that the reflection factor of the mirror plate (1) is greater in the short wave visible spectrum range than the long wave visible spectrum range.

4. Low glare mirror plate according to one of the preceding claims, **characterised in that** thicknesses of the first, second and third layers (4, 6, 8) are selected such that the integral reflection factor of the mirror plate (1) is in a range of between 43% and 53%, preferably between 48% and 52% and most preferably between 49% and 51%.

5. Low glare mirror plate according to one of the preceding claims, **characterised in that** the thickness of the first layer (4) of niobium pentoxide is 38 nm ± 10 nm.

6. Low glare mirror plate according to one of the preceding claims, **characterised in that** the thickness of the second layer (6) of silicon nitride is 49 nm ± 20 nm.

7. Low glare mirror plate according to one of the preceding claims, **characterised in that** the thickness of the mirror layer (8) of chromium is 50 nm ± 10 nm.

8. Low glare mirror plate according to one of the preceding claims, **characterised in that** the substrate (2) is slightly curved.

9. Low glare mirror plate according to one of the preceding claims, **characterised in that** the substrate (2) is made of glass.

10. Low glare mirror plate according to one of the preceding claims, **characterised in that** a fourth layer of protective lacquer (10) is applied onto the mirror layer (8) of chromium.

11. Method for the manufacture of a mirror plate according to one of the preceding claims with the steps of:
- providing a substrate (2) in an in-line sputtering device,
- sputtering the first layer (4) of niobium pentoxide onto the rear side of the substrate (2) made of a niobium pentoxide target,
- sputtering the second layer (6) of silicon nitride onto the first layer (4) made of a target of silicon with the addition of nitrogen, **characterised by**
- sputtering the mirror layer (8) of chromium onto the second layer (6) made of a target of chromium.

12. Method according to claim 11 **characterised by** the method step of applying a fourth layer of protective lacquer (10) onto the mirror layer.

13. Method according to one of the preceding claims 11 to 12, **characterised in that** the substrate (2) is guided past the stationary targets.

14. Low glare rearview mirror for motor vehicles with a mirror plate (1) according to one of the preceding claims 1 to 10.

## Revendications

1. Vitre-miroir anti-reflet, en particulier pour des rétroviseurs de véhicules automobiles, avec :
un substrat (2) transparent, avec une face avant, formant la face avant de la vitre-miroir (1), et une face arrière, une première couche (4) en oxyde de niobium, appliquée sur la face arrière du substrat (2),
une deuxième couche (6) en nitrure de silicium, appliquée sur la première couche (4), **caractérisée par**
une troisième couche (8) ou couche réfléchissante (8) en chrome, appliquée sur la deuxième couche (6).

2. Vitre-miroir anti-reflet selon la revendication 1,
**caractérisée en ce que** la première, la deuxième et/ou la troisième couche (4, 6, 8) sont des couches issue d'une pulvérisation cathodique.

3. Vitre-miroir anti-reflet selon la revendication 1 ou 2, **caractérisée en ce que** les épaisseurs de la première et de la deuxième couche (4, 6) sont choisies telles que le degré de réflexion de la vitre-miroir (1) dans la plage du spectre visible à ondes courtes est supérieur à ce qu'il est dans la plage du spectre visible à ondes longues.

4. Vitre-miroir anti-reflet selon l'une quelconque des revendications précédentes, **caractérisée en ce que** les épaisseurs de couche, concernant la première, la deuxième et la troisième couche (4, 6, 8) sont choisies telles que le degré de réflexion intégral de la vitre-miroir (1) est situé dans la fourchette comprise entre 43 % et 53 %, de préférence entre 48 % et 52 % et, de préférence, entre 49 % et 51 %.

5. Vitre-miroir anti-reflet selon l'une quelconque des revendications précédentes, **caractérisée en ce que** l'épaisseur de la première couche (4) en oxyde de niobium est de 38 nm ± 10 nm.

6. Vitre-miroir anti-reflet selon l'une quelconque des revendications précédentes, **caractérisée en ce que** l'épaisseur de la deuxième couche (6) en nitrure de silicium est de 49 nm ± 20 nm.

7. Vitre-miroir anti-reflet selon l'une quelconque des revendications précédentes, **caractérisée en ce que** l'épaisseur de la couche réfléchissante (8) en chrome est de 50 nm ± 10 nm.

8. Vitre-miroir anti-reflet selon l'une quelconque des revendications précédentes, **caractérisée en ce que** le substrat (2) est légèrement incurvé.

9. Vitre-miroir anti-reflet selon l'une quelconque des revendications précédentes, **caractérisée en ce que** le substrat (2) est composé de verre.

10. Vitre-miroir anti-reflet selon l'une quelconque des revendications précédentes, **caractérisée en ce qu'**une quatrième couche (10) en vernis protecteur est appliquée sur la couche réfléchissante (8) en chrome.

11. Procédé de fabrication d'une vitre-miroir selon l'une quelconque des revendications précédentes, comprenant les étapes de procédé consistant à :
- fournir un substrat (2) dans une installation de pulvérisation cathodique travaillant en ligne,
- appliquer par pulvérisation cathodique la première couche (4) en oxyde de niobium sur la face arrière du substrat (2) composé d'une cible en oxyde de niobium,
- appliquer par pulvérisation cathodique la deuxième couche (6) en nitrure de silicium sur la première couche (4) composée d'une cible en silicium, en ajoutant de l'azote, **caractérisé par**
- l'application par pulvérisation cathodique de la couche réfléchissante (8) en chrome sur la deuxième couche (6) réalisée en une cible en chrome.

12. Procédé selon la revendication 11, **caractérisé par** l'étape de procédé d'application d'une quatrième couche, composée d'un vernis protecteur (10), sur la couche réfléchissante (8).

13. Procédé selon l'une quelconque des revendications 11 à 12 précédentes, **caractérisé en ce que** le substrat (2) est passé sur la cible localement fixe.

14. Vitre-miroir anti-reflet pour des véhicules munis d'un rétroviseur (1) l'une quelconque des revendications 1 à 10 précédentes.
